# EUROPEAN PATENT APPLICATION

(11) **EP 3 770 299 A1**
(43) Date of publication of application: **27.01.2021**
(21) Application number: 19213361.9
(22) Date of filing: 03.12.2019
(51) Int. Cl.: C23C 22/24, C23C 16/455, C23C 28/04, F28F 19/00

(54) **CORROSION BARRIERS FOR HEAT EXCHANGERS**

(30) Priority: 26.07.2019 US 201916523283
(71) Applicant: Hamilton Sundstrand Corporation, Charlotte, NC 28217-4578 (US)
(72) Inventor: POTEET, Steven, 06518, CT Connecticut Hamden (US); SMITH, Blair, South Windsor, CT Connecticut 06074 (US)
(74) Representative: Dehns

(57) **Abstract**

A method (200) of applying a heat exchanger coating system includes forming a conversion coated substrate by applying a conversion coat (120) onto a substrate (110) to provide corrosion resistance to the substrate and encapsulating the conversion coated substrate with a pinhole-free, uniform, atomic layer deposited, corrosion resistant coating (130).

## Description

### BACKGROUND

The present disclosure relates generally to heat exchangers. More specifically, this disclosure relates to corrosion barrier coatings of heat exchangers.

Many components within an aircraft are coated with corrosion barriers to increase the useful life of the components by increasing the corrosion resistance of the components. There are various environmental insults that may be present in, for example, a gas turbine engine under load such as cyclic high temperatures. Some conventional corrosion barriers are able to partially mitigate the impact of corrosive environments within the aircraft. However, internal surfaces of some of these components may be non-line of sight and many conventional corrosion barrier systems are unable to coat the internal surfaces of components with complex internal geometries. Additionally, it is difficult to uniformly apply conventional corrosion barriers, leaving some areas inadequately covered and other areas thickened to the point of chipping off. These uncovered, inadequately covered, or chipped off areas are more prone to corrosion and degradation of the component at these sites, reducing the component's useful life.

### SUMMARY

A method of applying a heat exchanger coating system includes forming a conversion coated substrate by applying a conversion coat onto a substrate to provide corrosion resistance to the substrate and encapsulating the conversion coated substrate with a pinhole-free, uniform, atomic layer deposited, corrosion resistant coating.

A heat exchanger coating system includes a conversion coated substrate including a substrate and a conversion coat covering the substrate to provide corrosion resistance to the substrate, and a pinhole-free, uniform, atomic layer deposited, corrosion resistant coating encapsulating the conversion coated substrate.

### BRIEF DESCRIPTION OF THE DRAWINGS

FIG. 1A is a cross-sectional view of one embodiment of a component with a corrosion barrier system.
FIG. 1B is a cross-sectional view of another embodiment of a component with a corrosion barrier system.
FIGS. 2A-2D is one embodiment of a method for applying the corrosion barrier system on a component.
FIG. 3 is another embodiment of a method for applying the corrosion barrier system on a component.
FIGS. 4A-4C are comparative examples of coatings before and after exposure to a corrosive environment.
FIGS. 5A-5C are another set of comparative examples of coatings before and after exposure to a corrosive environment.

### DETAILED DESCRIPTION

Gas turbine engine corrosion is a common problem and can be linked to contaminants present in the air inlet systems, water systems, and fuel systems. For example, trace amounts of sulfur oxides and nitrogen oxides present in these systems can react with moisture in the air to create acidic environments within the gas turbine engine, including heat exchanger units. These acidic environments greatly increase the oxidation rate of metallic components within the engine if not properly protected. Even minor imperfections in a corrosion barrier system such as cracks and small holes in a coating can serve as nucleation sites for the onset of corrosion of the component.

Heat exchangers are typically designed with complex internal geometries in order to maximize the transfer of heat between two mediums. As such, many heat exchangers include a torturous flow path, which makes it very difficult to apply a corrosion barrier system deep within the core of the heat exchanger using conventional coating techniques, such as dipping, immersion baths, and spraying. This leaves the uncoated or inadequately coated internal metallic surfaces within the heat exchanger prone to corrosive damage.

Disclosed herein is a corrosion barrier system which extends the useful life of a component by increasing the component's resistance to corrosive environments within an aircraft. The disclosed corrosion barrier system results in a uniform pinhole-free coating that extends through non-line of sight passages and deep into the core of the component. Furthermore, the disclosed corrosion barrier system is more resistant to both neutral and acidic environments compared to conventional corrosion barrier systems.

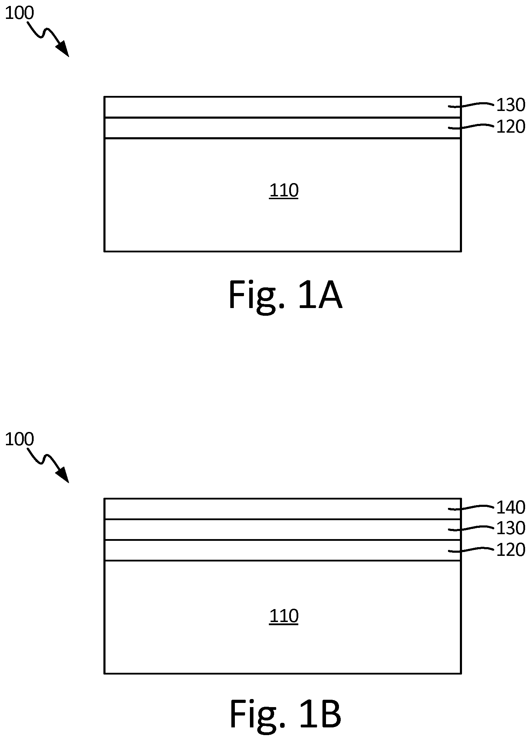

FIG. 1A is a cross-sectional view of one embodiment of a component with a corrosion barrier system. FIG. 1A shows component 100 including substrate 110, conversion coat 120, and corrosion resistant layer 130. Component 100 can be any component in need of corrosion protection within an aircraft such as, for example, heat exchangers, compressor sections, combustion sections, and turbine sections of a gas turbine engine.

In one embodiment, substrate 110 is formed of aluminum or an aluminum alloy. Alternatively, substrate 110 can be formed of other metals such as stainless steel, titanium, nickel, titanium alloy, or a nickel alloy. The use of a particular metal or alloy can be optimized based on the particular micro-environment to which the component will be exposed. For example, a component within the combustion section of a gas turbine engine can experience very high cyclic temperatures, and a component formed of nickel or a nickel alloy can tolerate better the cyclic high temperatures within the combustion section compared to a component formed of aluminum or an aluminum alloy. In other words, a component within the combustion section formed of nickel or a nickel alloy will crack, warp, or break less frequently or to a lesser degree compared to a component formed of aluminum or an aluminum alloy within the same combustion section.

Conversion coat 120 can be a non-rinse conversion coat containing hexavalent chromium such as, for example, Permatreat® 686A (Chemetall, Auckland, New Zealand) or BONDERITE® M-CR 600 AERO or BONDERITE® M-CR 1200 AERO (Henkel Corp., Dusseldorf, Germany). However, hexavalent chromium is a hazardous compound to work with and poses a significant environmental threat if not handled and disposed of properly. As such, conversion coat 120 can be a non-hexavalent chromium containing conversion coat, having ions selected from the group consisting of trivalent chromium, Mo, Mn, Zr, Ti, Ni, Zn, V, P, Co, La, Ce, rare earth metals, or combinations thereof.

Alternatively, conversion coat 120 can contain trivalent chromium ions and then be exposed to an oxidizer such as, for example, hydrogen peroxide or permanganate. This process converts the trivalent chromium to a hexavalent chromium state, which can provide increased corrosion protection compared to conversion coat 120 containing only trivalent chromium ions.

Conversion coat 120 can provide an active inhibition of corrosion should corrosion resistant coating 130 become compromised. Additionally, conversion coat 120 can increase the bond strength between substrate 110 and corrosion resistant coating 130 compared to the bond strength between substrate 110 and corrosion resistant coating 130 without a conversion coat.

Alternatively, conversion coat 120 can be an oxidation layer formed by, for example, sol-gel, boe-gel, or boehmite-like (steam generated oxide layer) processes. The sol-gel process, for example, can entail a cleaning and de-oxidation step to remove any native oxides on the surface of the component followed by application of the sol-gel to create an oxidation layer. The resultant oxidation layer helps to prevent further oxidation of underlying substrate 110 while also promoting adhesion of subsequently added corrosion resistant layer 130.

Alternatively, conversion coat 120 can entail additional pretreatment steps or different pretreatment steps when substrate 110 is formed of stainless steel, Ti, Ni, Ti alloy or Ni alloy. For example, a method such as AMS2700 using nitric acid, nitric acid and dichromate, or citric acid can be used to passivate stainless steel. The composition of conversion coat 120 and method of application can be optimized based on the composition of the underlying substrate 110 and the amount of corrosion protection needed in a particular location within a gas turbine engine.

Corrosion resistant layer 130 is a uniform pinhole-free layer covering conversion coat 120, including non-line of sight surfaces of component 100. For example, a heat exchanger with complex internal geometries will be uniformly coated with a pinhole-free layer deep within the core of the heat exchanger.

Corrosion resistant layer 130 is applied using atomic layer deposition (ALD) and can be formed of any elements or compounds compatible with ALD. For example, corrosion resistant layer 130 can be selected from the group consisting of a metal oxide, metal nitride, semiconductor, phosphor, fluoride, or combinations thereof.

Metal oxides, for example, can be selected from the group consisting of Al₂O₃, TiO₂, ZrO₂, HfO₂, Ta₂O₅, Nb₂O₅, Sc₂O₃, Y₂O₃, MgO, B₂O₃, SiO₂, GeO₂, La₂O₃, CeO₂, PrOₓ, Nd₂O₃, Sm₂O₃, EuOₓ, Gd₂O₃, Dy₂O₃, Ho₂O₃, Er₂O₃, Tm₂O₃, Yb₂O₃, Lu₂O₃, SrTiO₃, BaTiO₃, PbTiO₃, PbZrO₃, BixTiyO, BixSiyO, SrTa₂O₆, SrBi₂Ta₂O₉, YScO₃, LaAlO₃, NdAlO₃, GdScO₃, LaScO₃, LaLuO₃, LaYbO₃, Er₃Ga₅O₁₃, In₂O₃, In₂O₃:Sn, In₂O₃:F, In₂O₃:Zr, SnO₂, SnO₂:Sb, Sb₂O₃, ZnO, ZnO:Al, ZnO:B, ZnO:Ga, RuO₂, RhO₂, IrO₂, Ga₂O₃, VO₂, V₂O₅, WO₃, W₂O₃, NiO, CuOₓ, FeOₓ, CrOₓ, CoOₓ, MnOₓ, LaCoO₃, LaNiO₃, LaMnO₃, La₁-xCaₓMnO₃, and combinations thereof.

Metal nitrides, for example, can be selected from the group consisting of BN, AlN, GaN, InN, Si₃N₄, Ta₃N₅, Cu₃N, Zr₃N₄, Hf₃N₄, LaN, LuN, TiN, Ti-Si-N, Ti-Al-N, TaN, NbN, MoN, WNₓ, WNₓC_{y}, CoₓN, SnₓN, and combinations thereof.

Semiconductors, for example, can be selected from the group consisting of ZnS, ZnSe, ZnTe, CaS, SrS, BaS, CdS, CdTe, MnTe, GaAs, AlAs, AlP, InP, GaP, InAs, PbS, SnS, In₂S₃, Sb₂S₃, CuₓS, CuGaS₂, WS₂, SiC, Ge₂Sb₂Te₅ and combinations thereof.

Phosphors, for example, can be selected from the group consisting of ZnS:M (M=Mn,Tb,Tm); CaS:M (M=Eu, Ce, Tb, Pb); SrS:M(M=Ce, Tb, Pb), or combinations thereof.

Fluorides, for example, can be selected from the group consisting of CaF₂, SrF₂, MgF₂, LaF₃, ZnF₂ and combinations thereof.

Corrosion resistant layer 130 can also be formed of elements or compounds, for example, selected from the group consisting of Ru, Pt, Ir, Pd, Rh, Ag, Cu, Ni, Co, Fe, Mn, Ta, W, Mo, Ti, Al, Si, Ge, La₂S₃, Y₂O₂S, TiCₓ, TiS₂, TaCₓ, WCₓ, Ca₃(PO₄)₂, CaCO₃, and combinations thereof.

Corrosion resistant layer 130 can be made up of one sub-layer deposited by ALD. Alternatively, corrosion resistant layer 130 can be made up of multiple sub-layers deposited by ALD in an iterative process described elsewhere herein. Each sub-layer can be formed of the same elements and compounds or each sub-layer can be formed of different elements and compounds. Each sub-layer typically has a thickness of 5 to 10 nanometers (0.0002 to 0.0004 mils). However, corrosion resistant layer 130 can have a total thickness of between 1 and 500 nanometers (0.00004 and 0.02 mils), inclusive.

FIG. 1B is a cross-sectional view of another embodiment of a component with a corrosion barrier system. FIG. 1B shows component 100 including substrate 110, conversion coat 120, corrosion resistant layer 130, and top coat 140. Top coat 140 can be formed of, for example, silicone or a phenolic epoxy coating. Top coat 140 covers corrosion resistant layer 130 and is applied by spraying, painting, or bath immersion techniques and can have a thickness of 5-25 microns. Top coat 140 provides an additional layer of protection against environmental induced corrosion.

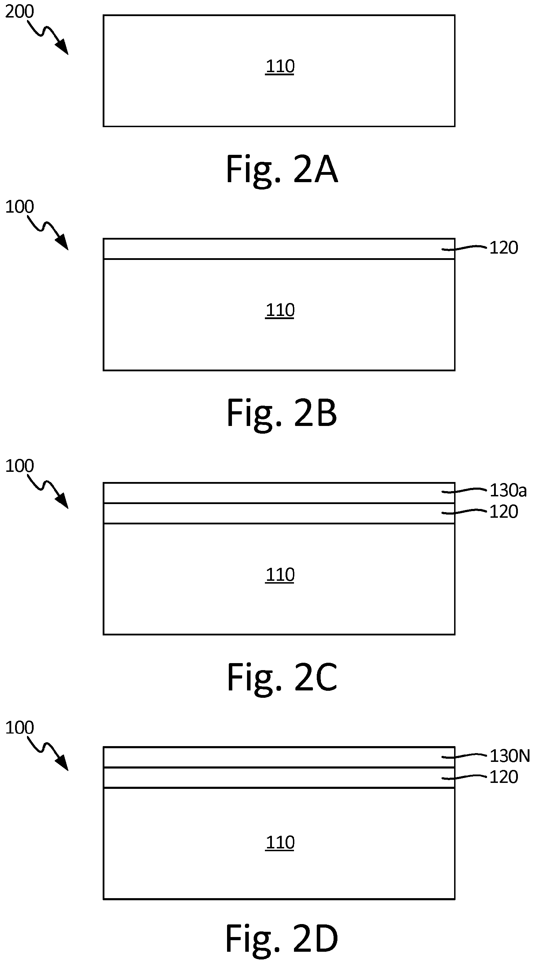

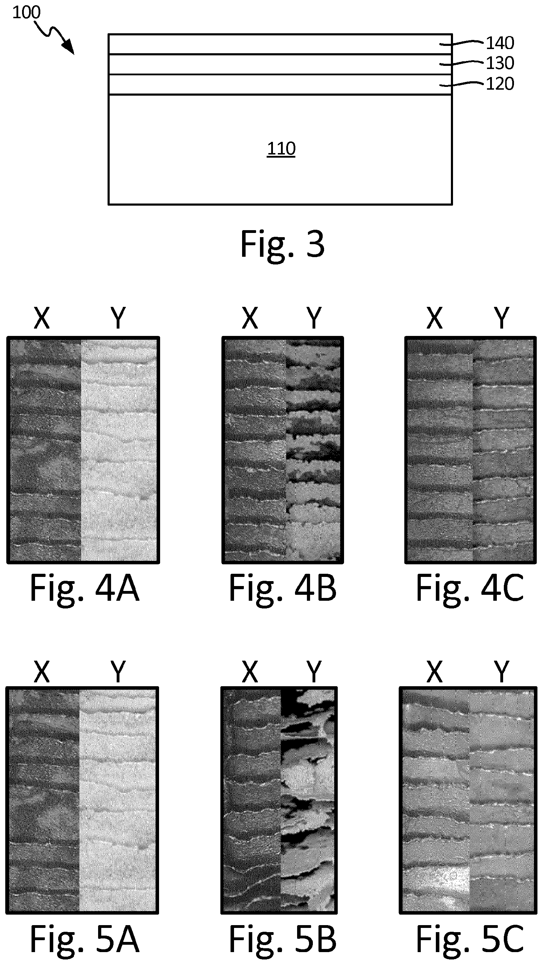

FIGS. 2A-2D and FIG. 3 are embodiments of process 200 for applying a corrosion barrier system on a component. FIG. 2A shows component 100 including substrate 110 without a coating. Process 200 begins by applying conversion coat 120 onto the surfaces of substrate 110, resulting in the component shown in FIG. 2B, which includes substrate 110 and conversion coat 120. Conversion coat 120 is applied using, for example, spraying, dipping, or immersion bath techniques.

Next, ALD is used to deposit corrosion resistant layer 130 on top of conversion coat layer 120. ALD first deposits a single monolayer of a first ALD precursor adsorbed on the surfaces of the component, including internal surfaces deep within the core of the component, which may have complex internal geometries. ALD is a self-limiting process and deposits only a single monolayer of the first precursor. Any non-adsorbed first precursor is removed from the system, leaving behind the ALD intermediate coated component, which includes substrate 110, conversion coat layer 120, and ALD intermediate corrosion resistant layer.

For Al₂O₃, the first precursor gas can be, for example, a volatile organometallic aluminum such as trimethyl aluminum or aluminum trichloride. For TiO₂, the first precursor gas can be, for example, a volatile titanium precursor such as TiCl₄. For SiO₂, the first precursor gas can be, for example, a volatile organometallic silicon.

Next, a second ALD precursor is added, which bonds only with the adsorbed first precursor in a self-limiting process. Any by-products or unreacted second precursor is removed from the system, leaving behind component 100 shown in FIG. 2C, including substrate 110, conversion coat 120, and corrosion resistant layer 130a. For oxides, the second precursor gas can be, for example, plasma O₂, H₂O, and O₃. For nitrides, the second precursor gas can be, for example, ammonia or plasma nitrogen.

Corrosion resistant layer 130 can be a single mono-layer deposited by ALD as described herein, shown in FIG. 2C and designated 130a. Alternatively, corrosion resistant layer 130 can be more than one mono-layer deposited by ALD and is designated as 130n (n can be any integer greater than 1, bounded by the total thickness of corrosion resistant layer from 1 to 500 nm, inclusive). The ALD steps are repeated, forming a second mono-layer making up corrosion resistant layer 130n. The ALD steps can be repeated in an iterative manner until a desired thickness of corrosion resistant layer 130n is formed. FIG. 2D shows component 100 including substrate 110, conversion coat 120, and corrosion resistant layer 130n.

Corrosion resistant layer 130 encapsulates the surfaces of component 100, which provides a uniform, pinhole-free coating deep into the core of component 100 and reduces corrosion in both neutral and acidic environments compared to a component without corrosion resistant layer 130 deposited by ALD.

In another embodiment of process 200, top coat 140 can be applied on top of corrosion resistant layer 130. FIG. 3 shows component 100 including substrate 110, conversion coat 120, corrosion resistant layer 130, and top coat 140, which provides additional corrosion protection to component 100. Top coat 140 protects component 100 from abrasive damage from dust or debris traveling at high velocities through or nearby component 100 compared to component 100 without top coat 140.

### EXAMPLES

FIGS. 4A-4C are comparative examples of coatings before and after exposure to a corrosive environment. FIG. 4A shows a series of fins within a heat exchanger coated with only a hexavalent chromium containing conversion coat (Permatreat® 686A) on an aluminum or aluminum alloy substrate. For the set of FIGS. 4A-4C and 5A-5C, brazed in fins formed of aluminum 3003 were sectioned and then coated so that the coating(s) would not be damaged by the cutting tools. Exposed samples were subjected to a 5% v/v sulfuric acid environment for 10 days at 25° C.

Column X shows the coated fins before exposure to the corrosive environment and column Y shows a dramatic color change indicating that the aluminum substrate is thoroughly oxidized after exposure to the corrosive environment. FIG. 4B shows a series of fins within a heat exchanger coated with only a corrosion resistant layer (250 nm layer of Nb₂O₅ deposited by ALD). Column X shows the coated fins before exposure to a corrosive environment and column Y shows a color change and flaking, indicating oxidative degradation of the aluminum substrate after exposure to the corrosive environment. FIG. 4C shows a series of fins within a heat exchanger coated with both, a conversion coat (Permatreat® 686A) and a corrosion resistant layer (250 nm layer of Nb₂O₅ deposited by ALD). Column X shows the coated fins before exposure to a corrosive environment and column Y shows little to no color change and no indication of flaking, indicating oxidative protection of the aluminum substrate after exposure to the corrosive environment.

FIGS. 5A-5C are comparative examples of coatings before and after exposure to a corrosive environment. FIG. 5A shows a series of fins within a heat exchanger coated with only a hexavalent chromium containing conversion coat (Permatreat® 686A) on an aluminum substrate. Column X shows the coated fins before exposure to a corrosive environment and column Y shows a dramatic color change indicating that the aluminum substrate is thoroughly oxidized after exposure to the corrosive environment. FIG. 5B shows a series of fins within a heat exchanger coated with only a corrosion resistant layer (500 nm layer of Nb₂O₅ deposited by ALD). Column X shows the coated fins before exposure to a corrosive environment and column Y shows a color change and flaking, indicating oxidative degradation of the aluminum substrate after exposure to the corrosive environment. FIG. 5C shows a series of fins within a heat exchanger coated with both, a conversion coat (Permatreat® 686A) and a corrosion resistant layer (500 nm layer of Nb₂O₅ deposited by ALD). Column X shows the coated fins before exposure to a corrosive environment and column Y shows little to no color change and no indication of flaking, indicating oxidative protection of the aluminum substrate after exposure to the corrosive environment.

Although not wanting to be limited by theory, it is believed that when only a corrosion resistant layer is applied, the corrosion resistant layer does not bond well to the underlying substrate and delaminates when stressed. Although hexavalent chromium and non-hexavalent chromium conversion coats can enhance the bond strength between the corrosion resistant layer and the underlying substrate, it is also believed that other processes, such as sol-gel, boe-gel, and boehmite-like (steam generated oxide layer) processes can also enhance the bond strength between the corrosion resistant layer and the underlying substrate.

### Discussion of Possible Embodiments

The following are non-exclusive descriptions of possible embodiments of the present invention.

A method of applying a heat exchanger coating system includes forming a conversion coated substrate by applying a conversion coat onto a substrate to provide corrosion resistance to the substrate and encapsulating the conversion coated substrate with a pinhole-free, uniform, atomic layer deposited, corrosion resistant coating.

The method of the preceding paragraph can optionally include, additionally and/or alternatively, any one or more of the following features, configurations and/or additional components:

The encapsulating the conversion coated substrate includes applying a first corrosion resistant coating layer by atomic layer deposition and applying a second corrosion resistant coating layer over the first corrosion resistant coating layer by atomic layer deposition.

The conversion coat includes hexavalent chromium.

The conversion coat includes non-hexavalent chromium selected from the group consisting of trivalent chromium, Mo, Mn, Zr, Ti, Ni, Zn, V, P, Co, La, Ce, rare earth metals, and combinations thereof.

The conversion coat is an oxidation layer formed by a sol-gel, boe-gel, or boehmite process.

The substrate is formed of aluminum or an aluminum alloy.

The substrate is formed of stainless steel, Ti, Ni, Ti alloy, or Ni alloy.

The method includes applying a topcoat over the corrosion resistant coating.

The topcoat is formed of a phenolic epoxy or silicone.

The corrosion resistant coating is formed from the group consisting of a metal oxide, metal nitride, semiconductor, phosphor, fluoride, and combinations thereof.

A heat exchanger coating system includes a conversion coated substrate including a substrate and a conversion coat covering the substrate to provide corrosion resistance to the substrate, and a pinhole-free, uniform, atomic layer deposited, corrosion resistant coating encapsulating the conversion coated substrate.

The heat exchanger of the preceding paragraph can optionally include, additionally and/or alternatively, any one or more of the following features, configurations and/or additional components:

The conversion coat includes hexavalent chromium.

The conversion coat includes non-hexavalent chromium selected from the group consisting of trivalent chromium, Mo, Mn, Zr, Ti, Ni, Zn, V, P, Co, La, Ce, rare earth metals, and combinations thereof.

The conversion coat is an oxidation layer formed by a sol-gel, boe-gel, or boehmite process.

The substrate is formed of aluminum or an aluminum alloy.

The substrate is formed of stainless steel, Ti Ni, Ti alloy, or Ni alloy.

The system includes a topcoat over the corrosion resistant coating.

The corrosion resistant coating is formed from the group consisting of a metal oxide, metal nitride, semiconductor, phosphor, fluoride, and combinations thereof.

The metal oxide is selected from the group consisting of Al₂O₃, TiO₂, ZrO₂, HfO₂, Ta₂O₅, Nb₂O₅, Sc₂O₃, Y₂O₃, MgO, B₂O₃, SiO₂, GeO₂, La₂O₃, CeO₂, PrOₓ, Nd₂O₃, Sm₂O₃, EuOₓ, Gd₂O₃, Dy₂O₃, Ho₂O₃, Er₂O₃, Tm₂O₃, Yb₂O₃, Lu₂O₃, SrTiO₃, BaTiO₃, PbTiO₃, PbZrO₃, BixTiyO, BixSiyO, SrTa₂O₆, SrBi₂Ta₂O₉, YScO₃, LaAlO₃, NdAlO₃, GdScO₃, LaScO₃, LaLuO₃, LaYbO₃, Er₃Ga₅O₁₃, In₂O₃, In₂O₃:Sn, In₂O₃:F, In₂O₃:Zr, SnO₂, SnO₂:Sb, Sb₂O₃, ZnO, ZnO:Al, ZnO:B, ZnO:Ga, RuO₂, RhO₂, IrO₂, Ga₂O₃, VO₂, V₂O₅, WO₃, W₂O₃, NiO, CuOₓ, FeOₓ, CrOₓ, CoOₓ, MnOₓ, LaCoO₃, LaNiO₃, LaMnO₃, La₁-xCaₓMnO₃, and combinations thereof.

The metal nitride is selected from the group consisting of BN, AlN, GaN, InN, Si₃N₄, Ta₃N₅, Cu₃N, Zr₃N₄, Hf₃N₄, LaN, LuN, TiN, Ti-Si-N, Ti-Al-N, TaN, NbN, MoN, WNₓ, WNₓC_{y}, CoₓN, SnₓN, and combinations thereof.

While the invention has been described with reference to an exemplary embodiment(s), it will be understood by those skilled in the art that various changes may be made and equivalents may be substituted for elements thereof without departing from the scope of the claims. In addition, many modifications may be made to adapt a particular situation or material to the teachings of the invention as defined by the claims without departing from the scope thereof. Therefore, it is intended that the invention not be limited to the particular embodiment(s) disclosed, but that the invention will include all embodiments falling within the scope of the appended claims.

## Claims

1. A method (200) of applying a heat exchanger coating system, the method comprising:
forming a conversion coated substrate by applying a conversion coat (120) onto a substrate (110) to provide corrosion resistance to the substrate; and
encapsulating the conversion coated substrate with a pinhole-free, uniform, atomic layer deposited, corrosion resistant coating (130).

2. The method of claim 1, wherein encapsulating the conversion coated substrate comprises applying a first corrosion resistant coating layer by atomic layer deposition and applying a second corrosion resistant coating layer over the first corrosion resistant coating layer by atomic layer deposition.

3. The method of claim 1 or 2, wherein the conversion coat includes hexavalent chromium; or wherein the conversion coat includes non-hexavalent chromium selected from the group consisting of trivalent chromium, Mo, Mn, Zr, Ti, Ni, Zn, V, P, Co, La, Ce, rare earth metals, and combinations thereof.

4. The method of any preceding claim, wherein the conversion coat is an oxidation layer formed by a sol-gel, boe-gel, or boehmite process.

5. The method of any preceding claim, wherein the substrate is formed of aluminum or aluminum alloy; or wherein the substrate is formed of stainless steel, Ti, Ni, Ti alloy, or Ni alloy.

6. The method of any preceding claim, further comprising:
applying a topcoat over the corrosion resistant coating, wherein the topcoat is formed of a phenolic epoxy or silicone.

7. The method of any preceding claim, wherein the corrosion resistant coating is formed from the group consisting of a metal oxide, metal nitride, semiconductor, phosphor, fluoride, and combinations thereof.

8. A heat exchanger coating system comprising:
a conversion coated substrate including a substrate (110) and a conversion coat (120) covering the substrate to provide corrosion resistance to the substrate; and
a pinhole-free, uniform, atomic layer deposited, corrosion resistant coating encapsulating the conversion coated substrate (130).

9. The system of claim 8, wherein the conversion coat includes hexavalent chromium; or wherein the conversion coat includes non-hexavalent chromium selected from the group consisting of trivalent chromium, Mo, Mn, Zr, Ti, Ni, Zn, V, P, Co, La, Ce, rare earth metals, and combinations thereof.

10. The system of claim 8 or 9, wherein the conversion coat is an oxidation layer formed by a sol-gel, boe-gel, or boehmite process.

11. The system of any of claims 8 to 10, wherein the substrate is formed of aluminum or aluminum alloy; or wherein the substrate is formed of stainless steel, Ti, Ni, Ti alloy, or Ni alloy.

12. The system of any of claims 8 to 11 and further comprising:
a topcoat over the corrosion resistant coating; optionally wherein the topcoat is formed of a phenolic epoxy or silicone.

13. The system of any of claims 8 to 12, wherein the corrosion resistant coating is formed from the group consisting of a metal oxide, metal nitride, semiconductor, phosphor, fluoride, and combinations thereof.

14. The system of claim 13, wherein the metal oxide is selected from the group consisting of Al₂O₃, TiO₂, ZrO₂, HfO₂, Ta₂O₅, Nb₂O₅, Sc₂O₃, Y₂O₃, MgO, B₂O₃, SiO₂, GeO₂, La₂O₃, CeO₂, PrOₓ, Nd₂O₃, Sm₂O₃, EuOₓ, Gd₂O₃, Dy₂O₃, Ho₂O₃, Er₂O₃, Tm₂O₃, Yb₂O₃, Lu₂O₃, SrTiO₃, BaTiO₃, PbTiO₃, PbZrO₃, BixTiyO, BixSiyO, SrTa₂O₆, SrBi₂Ta₂O₉, YScO₃, LaAlO₃, NdAlO₃, GdScO₃, LaScO₃, LaLuO₃, LaYbO₃, Er₃Ga₅O₁₃, In₂O₃, In₂O₃:Sn, In₂O₃:F, In₂O₃:Zr, SnO₂, SnO₂:Sb, Sb₂O₃, ZnO, ZnO:Al, ZnO:B, ZnO:Ga, RuO₂, RhO₂, IrO₂, Ga₂O₃, VO₂, V₂O₅, WO₃, W₂O₃, NiO, CuOₓ, FeOₓ, CrOₓ, CoOₓ, MnOₓ, LaCoO₃, LaNiO₃, LaMnO₃, La₁-xCaₓMnO₃, and combinations thereof.

15. The system of claim 13 or 14, wherein the metal nitride is selected from the group consisting of BN, AlN, GaN, InN, Si₃N₄, Ta₃N₅, Cu₃N, Zr₃N₄, Hf₃N₄, LaN, LuN, TiN, Ti-Si-N, Ti-Al-N, TaN, NbN, MoN, WNₓ, WNₓC_{y}, CoₓN, SnₓN, and combinations thereof.
